Europäisches Patentamt

European Patent Office

Office européen des brevets

(11) Publication number : **0 545 528 A1**

## (12) EUROPEAN PATENT APPLICATION

(21) Application number : 92309189.6

(22) Date of filing : 08.10.92

(51) Int. Cl.⁵ : **H04N 5/335, H04N 5/228**

(30) Priority : **08.10.91 JP 260172/91**

(43) Date of publication of application :
**09.06.93 Bulletin 93/23**

(84) Designated Contracting States :
**DE FR GB**

(71) Applicant : **NEC CORPORATION**
**7-1, Shiba 5-chome Minato-ku**
**Tokyo 108-01 (JP)**

(72) Inventor : **Tajima, Kazuhisa, NEC Corporation**
**7-1 Shiba 5-chome, Minato-ku**
**Tokyo (JP)**

(74) Representative : **Moir, Michael Christopher et**
**al**
**MATHYS & SQUIRE, 10 Fleet Street**
**London EC4Y 1AY (GB)**

(54) **Signal dynamic increase of a video camera.**

(57)   A video camera light-receiving device in-
cludes a spectroscope (103), a first CCD (101), a
second CCD (102), and a signal processing
section (105). The spectroscope (103) separates
object light (108) containing a video signal into
two object beams (108a,108b). The first CCD
(101) receives one of the object beams (108a)
and outputs a photoelectrically converted sig-
nal (A). The second CCD (102) receives the
other of the object beams (108b) and outputs a
photoelectrically converted signal (B). The sig-
nal processing section (105) synchronously
adds and synthesizes the photoelectrically con-
verted signal $\bar{A}$ output from the first CCD and
the photoelectrically converted signal (B) output from the second CCD.

FIG.1

## Background of the Invention

The present invention relates to a video camera light-receiving device and, more particularly, to a video camera light-receiving device using a solid-state imaging device.

A video camera is used as a device for converting light containing video information into an electrical signal, and recording the electrical signal to record the video information.

In this video camera, a charge-coupled device (CCD) as a solid-state imaging device is used as a light-receiving device for converting input light containing video information into an electrical signal.

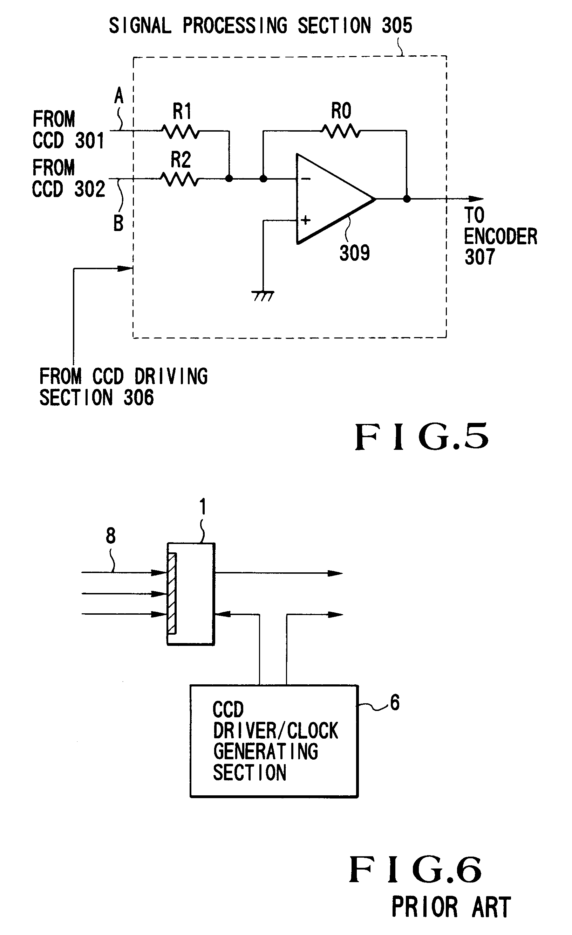

Fig. 6 shows the arrangement of a conventional light-receiving device using a CCD. Referring to Fig. 6, reference numeral 1 denotes a CCD; 8, light containing video information; and 6, a CCD driver/clock generating section for controlling the CCD 1.

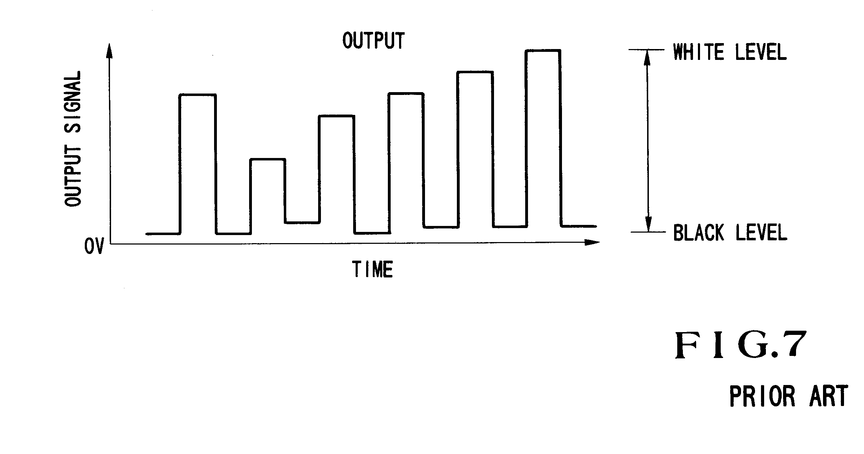

The light 8 containing video information is focused on the CCD 1 through a lens (not shown) and the like. The light 8 is photoelectrically converted by the CCD 1 and is output as an electrical signal. The photoelectrically converted output signal from the CCD 1 is output in the manner shown in Fig. 7. In the subsequent circuit, whether each pixel of the signal is white or black is determined on the basis of a predetermined threshold level set between the white level and black level of the signal.

Owing to the above-described arrangement of the conventional light-receiving device, a decrease in size of each light-receiving cell of the CCD and an increase in operating speed thereof will lead to a reduction in effective light-receiving area and storage time of electrons, thus causing a decrease in level of an output signal from the CCD. As a result, the S/N ratio is also decreased. This imposes limitations on the attempts to reduce the size of each light-receiving cell.

More specifically, the physical characteristics of the CCD, which appear when a light signal is converted into an electrical signal, become noise. Therefore, even if an output signal itself from the CCD, whose level is decreased because of a reduction in size of each light-receiving cell, is amplified, the noise is also amplified, interfering with an increase in S/N ratio.

## Summary of the Invention

It is an object of the present invention to provide a video camera light-receiving device in which the S/N ratio based on noise inherent in each solid-state imaging device is increased.

It is another object of the present invention to provide a video camera light-receiving device which can be operated even by a signal, output from a solid-stage imaging device, whose level is decreased with a reduction in size of the device.

In order to achieve the above objects, according to the present invention, there is provided a video camera light-receiving device comprising means for separating object light containing a video signal into two object beams, a first solid-state imaging device for receiving one of the object beams and outputting a photoelectrically converted signal, a second solid-state imaging device for receiving the other of the object beams and outputting a photoelectrically converted signal, and signal processing means for synchronously adding and synthesizing the photoelectrically converted signal output from the first solid-state imaging device and the photoelectrically converted signal output from the second solid-state imaging device.

In another aspect directed to the above objects, the invention provides a video camera light-receiving device characterised by comprising:

means for separating object light containing a video signal into a plurality of beams;

respective solid-state imaging devices for each receiving one of the object beams and outputting a photoelectrically converted signal (A);

signal processing means for synchronously adding and synthesizing the photoelectrically converted signals (A) output from said imaging devices to provide an output with an improved signal-to-noise ratio.

## BRIEF DESCRIPTION OF THE DRAWINGS

Figure 1 is a block diagram showing the arrangement of a video camera light-receiving device according to an embodiment of the present invention;

Figs. 2A and 2B are charts showing the relationship between the input signal level and the output signal level of a signal processing section in Fig. 1;

Fig. 3 is a block diagram showing the arrangement of a video camera light-receiving device according to another embodiment of the present invention;

Fig. 4 is a block diagram showing the arrangement of a video camera light-receiving device according to still another embodiment of the present invention;

Fig. 5 is a circuit diagram showing a signal processing section in Fig. 4;

Fig. 6 is a block diagram showing the arrangement of a main part of a conventional video camera light-receiving device; and

Fig. 7 is a chart showing the output signal level of a solid-state imaging device in Fig. 6.

## Description of the Preferred Embodiments

Embodiments of the present invention will be described below with reference to the accompanying drawings.

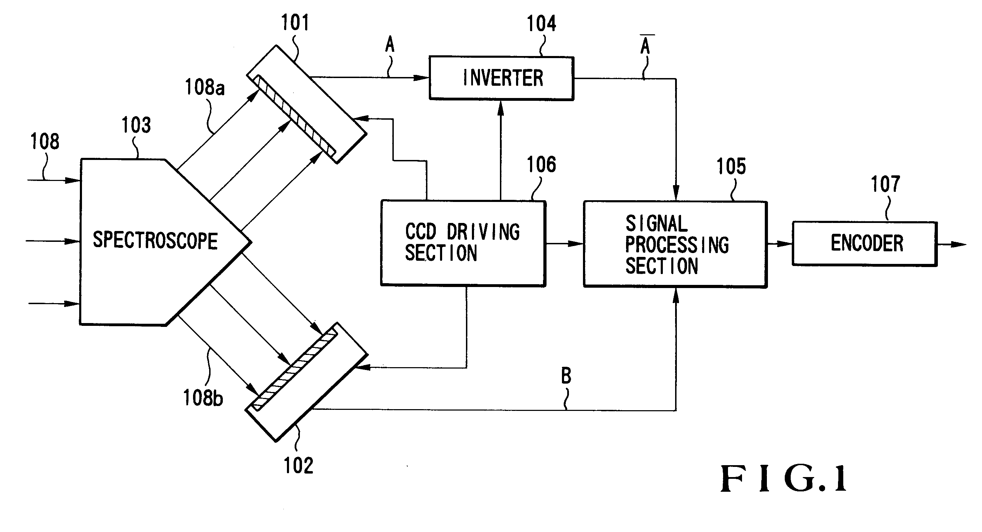

Fig. 1 shows the arrangement of a video camera light-receiving device according to an embodiment of the present invention. Referring to Fig. 1, reference numeral 101 denotes a first CCD for performing photoelectric conversion to extract a one-dimensional electrical signal from a two-dimensional optical image; 102, a second CCD having the same characteristics as those of the first CCD 101; 103, a spectroscope for separating light 108 (two-dimensional optical image) containing video information (to be imaged) into two video beams 108a and 108b, and distributing them to the first and second CCDs 101 and 102, respectively; 104, an inverter for inverting the phase of a photoelectrically converted signal A output from the first CCD 101; 105, a signal processing section for synthesizing an inverted signal $\overline{A}$ output from the inverter 104 with a photoelectrically converted signal B output from the second CCD 102; 106, a CCD driving section including a clock generating circuit, a timing circuit, a CCD driver, and the like and designed to drive the first and second CCDs 101 and 102; and 107, an encoder for encoding the signal synthesized by the signal processing section 105, together with other signals (not shown), into a predetermined color image signal of the NTSC scheme, the PAL scheme, or the like.

An operation of the video camera light-receiving device will be described next.

The light 108 passing through an optical system lens (not shown) of the video camera is separated by the spectroscope 103 in two directions and reach the surfaces of the first and second CCDs 101 and 102.

A first separated beam 108a which reaches the first CCD 101 is photoelectrically converted to be output as the electrical signal A. The phase of the electrical signal A is then inverted by the inverter 104, and the resultant inverted signal $\overline{A}$ is input to the signal processing section 105.

A second separated beam 108b which reaches the second CCD 102 is photoelectrically converted to be output as an electrical signal B, as in the case of the first CCD 101. The electrical signal B is directly input to the signal processing section 105.

Since the first and second CCDs 101 and 102 are driven by the same CCD driving section 106, the inverted signal $\overline{A}$ obtained by the first CCD 101 and the inverter 104 and the photoelectrically converted signal B output from the second CCD $10_2$ have amplitudes of opposite phases but are synchronized with each other, as shown in 2A.

These signals $\overline{A}$ and B are differentially added/synthesized by the signal processing section 105, as shown in Fig. 2B. As a result, a series of output signal components are all doubled in level between the white level and the black level. Accordingly, the range of the white level to the black level is doubled.

In this case, noise components based on the physical factors and thermoelectrons on the CCD surfaces and contained in the two signals input to the signal processing section 105 are irregularly generated and are not synchronized with a clock signal. For this reason, even if the noise components are added by the signal processing section 105, the amplitude is not doubled, and hence the noise components in the output signal are not doubled in level.

The output signal synthesized by the signal processing section 105, therefore, is a signal whose S/N ratio is increased.

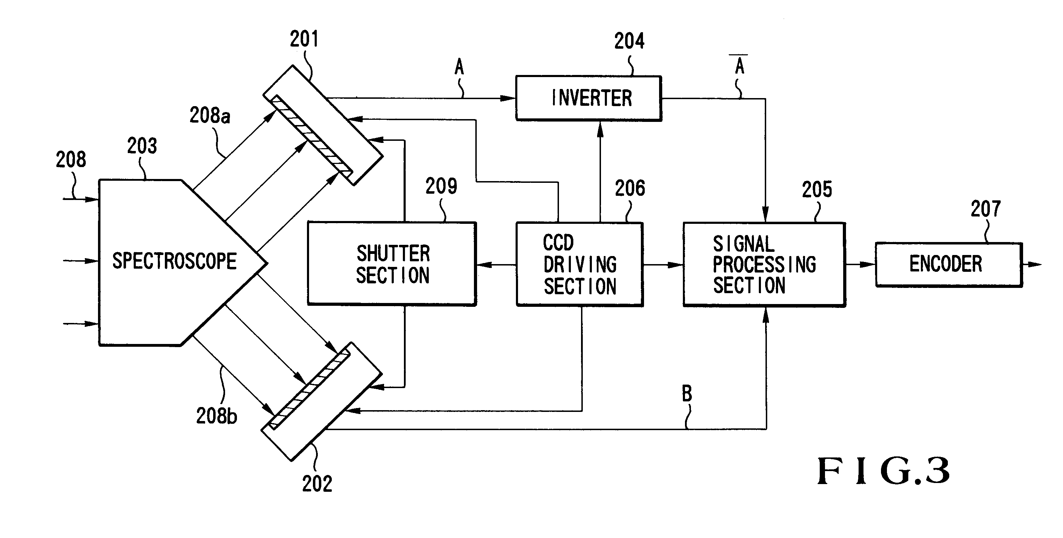

Fig. 3 shows the arrangement of a video camera light-receiving device according to another embodiment of the present invention. The device of this embodiment includes a shutter function of shortening the time required for a CCD to pick up light containing video information (storage time) from a normal time of 1/60 seconds to, e.g., 1/500 seconds or 1/1000 seconds, thereby increasing the resolution in a case wherein video information representing a fast motion is picked up. This shutter function is realized by applying a reset voltage to the CCD to remove an unnecessary charge stored therein, and storing a charge through light containing video information by the above-mentioned storage time.

Referring to Fig. 3, reference numeral 209 denotes a shutter section controlled by a CCD driving section 206 and designed to cause first and second CCDs 201 and 202 to perform shutter operations. Since other components are the same as those in Fig. 1, a description thereof will be omitted. The shutter section 209 applies a voltage several times higher than a normal voltage to the first and second CCDs 201 and 202 to forcibly sweep the charge stored therein so as to shorten the time required for photoelectric conversion, thus causing the CCDs 201 and 202 to pick up light containing video information. By repeating this operation at a short period, blurring of a moving object image is reduced, and the resolution is increased. However, the sensitivity is decreased because the amount of light picked up is decreased.

Similar to the case described with reference to Fig. 1, the phase of a photoelectrically converted signal A output from the first CCD 201 is inverted by an inverter 204, and a resultant inverted signal $\overline{A}$ and a photoelectrically converted signal B output from the second CCD 202 are differentially added/synthesized by a signal processing section 205. With this operation, the decrease in output signal level due to the shutter operations is compensated, and the S/N ratio can be increased.

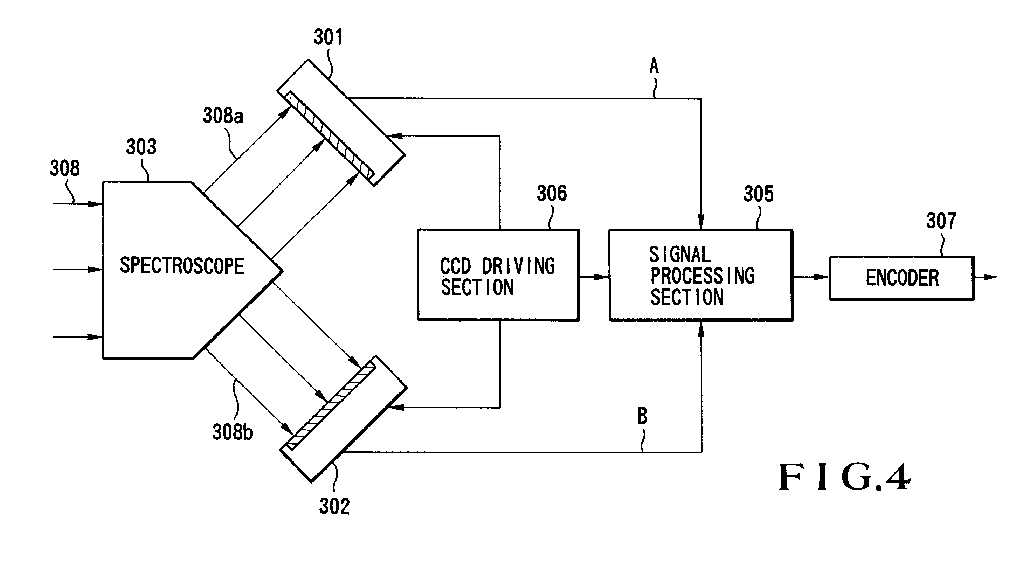

Fig. 4 shows the arrangement of a video camera light-receiving device according to still another embodiment of the present invention. In the device shown in Fig. 1, the phase of the photoelectrically converted signal A output from the first CCD 101 is inverted by the inverter 104, and the inverted signal $\overline{A}$ is differentially synthesized with the photoelectrically converted signal B output from the second CCD 102. According to this embodiment, as shown in Fig. 4, the device includes a signal processing section 305 for receiving a photoelectrically converted signal A output from a first CCD 301 and a photoelectrically converted signal B output from a second CCD 302. The two photoelectrically converted signals A and B are synchronously added/synthesized by the signal processing section 305. With this arrangement, in this embodiment, the inverter 104 shown in Fig. 1 can be omitted.

Fig. 5 shows a known analog adder constituting the signal processing section 305. Referring to Fig. 5, reference numeral 309 denotes an operational amplifier. Reference symbol R0 denotes a feedback resistor; and R1 and R2, input resistors. In this adder, the currents of the photoelectrically converted signals A and B input from the CCDs 301 and 302 are added by the resistors R1 and R2. The resultant signal is amplified by the operational amplifier 309 and is output to an encoder 307.

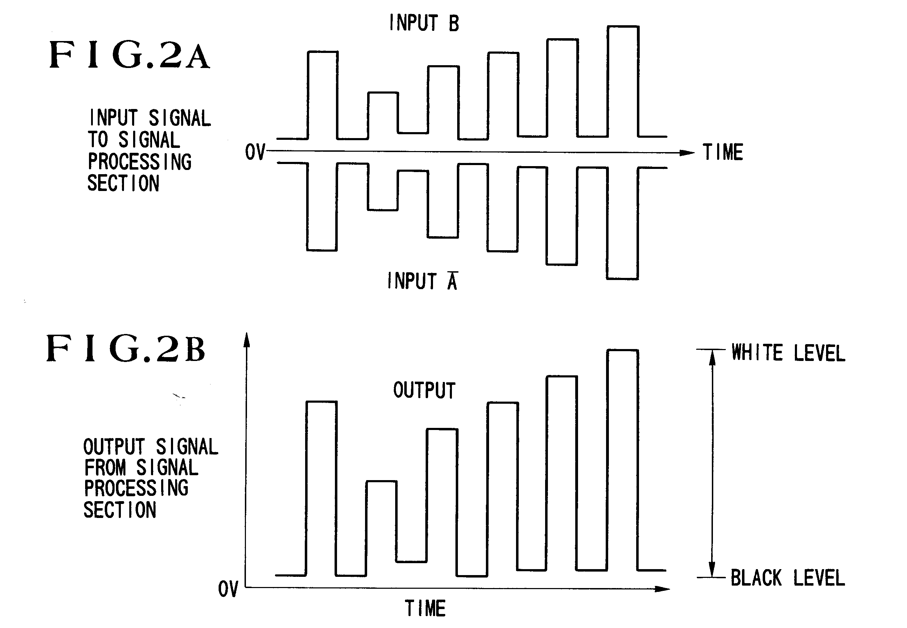

Note that in the device shown in Fig. 2, the photoelectrically converted signals A and B output from the two CCDs may also be added/synthesized by the signal processing section instead of differentially synthesizing the two signals by using the inverter.

As has been described above, according to the present invention, since only signal components of photoelectrically converted signals can be amplified without increasing noise, of the electrical signals, which are caused by physical information on solid-state imaging device surfaces in photoelectrical conversion, it is theoretically expected that the S/N ratio is increased about 1.4 times. Therefore, even in a case wherein the amount of light picked up is small, as in a case wherein the video camera photographs a dark place or performs a shutter operation, since the high S/N ratio is achieved, photoelectrically converted signals can be amplified without increasing the noise, thus improving the sensitivity.

## Claims

1. A video camera light-receiving device characterized by comprising:

    means (103, 203, 303) for separating object light containing a video signal into two object beams;

    a first solid-state imaging device (101, 201, 301) for receiving one of the object beams and outputting a photoelectrically converted signal (A);

    a second solid-state imaging device (102, 202, 302) for receiving the other of the object beams and outputting a photoelectrically converted signal (B); and

    signal processing means (105, 205, 305) for synchronously adding and synthesizing the photoelectrically converted signal (A) output from said first solid-state imaging device (101, 201, 301) and the photoelectrically converted signal (B) output from said second solid-state imaging device (102, 202, 302).

2. A device according to claim 1, further comprising phase inverting means (104) for inverting a phase of the photoelectrically converted signal (A) output from said first solid-state imaging device (101, 201, 301), and wherein said signal processing means (105, 205, 305) differentially synthesizes an inverted signal ($\overline{A}$) output from said phase inverting means (104) and the photoelectrically converted signal (B) output from said second solid-state imaging device (102, 202, 302).

3. A device according to claim 1, wherein said signal processing means (105, 205, 305) comprises an analog adder for adding the two photoelectrically converted signals (A, B) output from said first and second solid-state imaging devices (101, 201, 301; 102, 202, 302) in an analog manner.

4. A device according to any preceding claim, further comprising shutter operation control means (209) for forcibly resetting said first and second solid-state imaging devices (101, 201, 301; 102, 202, 302) at a short period and causing said solid-state imaging devices to receive light for a short period of time in every period.

5. A video camera light-receiving device characterised by comprising:

    means (103, 203, 303) for separating object light containing a video signal into a plurality of beams;

    respective solid-state imaging devices (101, 201, 301, 102, 202, 302) for each receiving one of the object beams and outputting a photoelectrically converted signal (A);

    signal processing means (105, 205, 305) for synchronously adding and synthesizing the photoelectrically converted signals (A) output from said imaging devices (101, 201, 301, 102, 202, 302) to provide an output with an improved signal-to-noise ratio.

F I G.1

EP 0 545 528 A1

# FIG.2A

INPUT SIGNAL
TO SIGNAL
PROCESSING
SECTION

INPUT B

0V ——————————————————→ TIME

INPUT A̅

# FIG.2B

OUTPUT SIGNAL
FROM SIGNAL
PROCESSING
SECTION

OUTPUT

WHITE LEVEL

BLACK LEVEL

0V

TIME

EP 0 545 528 A1

# FIG.3

207 ENCODER

205 SIGNAL PROCESSING SECTION

204 INVERTER

206 CCD DRIVING SECTION

209 SHUTTER SECTION

$\overline{A}$

A

B

201

202

203 SPECTROSCOPE

208a

208b

208

7

FIG.4

EP 0 545 528 A1

SIGNAL PROCESSING SECTION 305

FROM CCD 301

FROM CCD 302

FROM CCD DRIVING
SECTION 306

TO ENCODER 307

309

**F I G.5**

8

1

CCD
DRIVER/CLOCK
GENERATING
SECTION

6

**F I G.6**
PRIOR ART

OUTPUT

OUTPUT SIGNAL

WHITE LEVEL

BLACK LEVEL

0V

TIME

FIG.7

PRIOR ART

EP 0 545 528 A1

European Patent
Office

**EUROPEAN SEARCH REPORT**

Application Number

EP    92 30 9189

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | WO-A-9 112 690 (SCANERA S.C.)<br>* page 4, line 15 - page 5, line 27 *<br>* page 6, line 4 - line 18 *<br>* page 6, line 29 - page 7, line 16 *<br>* page 8, line 18 - page 9, line 21 *<br>* page 11, line 29 - line 33 *<br>* page 27, line 26 - page 29, line 7 * | 1,4 | H04N5/335<br>H04N5/228 |
| A | | 5 | |
| Y | US-A-4 584 606 (NAGASAKI)<br>* column 2, line 56 - column 3, line 48 * | 1,5 | |
| A | | 3 | |
| Y | US-A-4 614 966 (YUNOKI ET AL.)<br>* column 1, line 24 - line 45 *<br>* column 3, line 1 - column 6, line 61 * | 1,5 | |
| A | | 4 | |
| A | PATENT ABSTRACTS OF JAPAN<br>vol. 8, no. 181 (E-261)21 August 1984<br>& JP-A-59 072 875 ( NIPPON DENKI K.K. ) 24 April 1984<br>* abstract * | 1,5 | TECHNICAL FIELDS SEARCHED (Int. Cl.5)<br><br>H04N |
| A | PATENT ABSTRACTS OF JAPAN<br>vol. 14, no. 324 (E-951)11 July 1990<br>& JP-A-21 07 076 ( OLYMPUS OPTICAL CO. LTD. ) 19 April 1990<br>* abstract * | 1,5 | |
| A,P | PATENT ABSTRACTS OF JAPAN<br>vol. 16, no. 097 (E-1176)10 March 1992<br>& JP-A-32 76 973 ( CANON INC. ) 9 December 1991<br>* abstract * | 1,5 | |

The present search report has been drawn up for all claims

| Place of search | Date of completion of the search | Examiner |
|---|---|---|
| THE HAGUE | 04 FEBRUARY 1993 | DUHR R.H.J.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)